(19) **Europäisches Patentamt**
European Patent Office
Office européen des brevets

(11) **EP 2 551 982 B1**

(12) **EUROPÄISCHE PATENTSCHRIFT**

(45) Veröffentlichungstag und Bekanntmachung des Hinweises auf die Patenterteilung:
**25.09.2013 Patentblatt 2013/39**

(21) Anmeldenummer: **11175544.3**

(22) Anmeldetag: **27.07.2011**

(51) Int Cl.:
***H02H 6/00*** *(2006.01)*

(54) **Thermische Überwachung eines Umrichters**

Thermal monitoring of a converter

Surveillance thermique d'un convertisseur

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**30.01.2013 Patentblatt 2013/05**

(73) Patentinhaber: **Siemens Aktiengesellschaft 80333 München (DE)**

(72) Erfinder: **Kuhn, Andreas 09123 Chemnitz (DE)**

(56) Entgegenhaltungen:
**EP-A2- 1 583 197      WO-A1-2005/101431 US-A1- 2004 008 457      US-A1- 2005 270 707**

**Beschreibung**

Die vorliegende Erfindung betrifft ein Verfahren zur thermischen Überwachung eines Umrichters für einen Elektromotor eines Fahrzeugs, wobei die Temperatur des Umrichters gemessen wird. Darüber hinaus betrifft die vorliegende Erfindung eine Überwachungsvorrichtung zur thermischen Überwachung des Umrichters mit einer Messeinrichtung zum Messen der Temperatur des Umrichters.

Verbrennungskraftmaschinen in Kraftfahrzeugen werden meist durch eine Flüssigkeitskühlung gekühlt. Fällt diese Kühlung aus, so steigt die Temperatur des Verbrennungsmotors abhängig von Lastzahl und Umgebungsbedingungen an. Dieser Anstieg kann durch ein entsprechendes Anzeigeelement im Sichtbereich des Fahrers beobachtet werden. Meist wird bei Überschreiten einer kritischen Schwelle noch ein zusätzliches akustisches und/ oder optisches Signal erzeugt, das den Fahrer auf diesen Zustand aufmerksam macht. Die sogenannte Zeitkonstante (Zeit, in der eine bestimmte Temperaturdifferenz überwunden wird) für den Temperaturanstieg liegt im Bereich mehrerer Minuten und ermöglicht dem Fahrzeugführer nach dem Erkennen der Fehlfunktion noch ein gefahrloses Stillsetzen des Fahrzeugs.

Bei Umrichtern für den elektrischen Antrieb von Kraftfahrzeugen wird häufig ebenfalls eine Flüssigkeitskühlung mit ähnlichem Aufbau verwendet. Da jedoch die Masse eines Umrichters wesentlich geringer ist, als diejenige eines Verbrennungsmotors, liegen hier die thermischen Zeitkonstanten nur im Bereich einiger zehn Sekunden, d.h. der Zeitraum zwischen dem Erkennen eines übermäßigen Temperaturanstiegs und der möglichen Zerstörung des Umrichters durch Übertemperatur ist verhältnismäßig kurz.

In üblichen Industrieapplikationen wird nach Erkennen der Übertemperatur eine Warnung abgesetzt. Bei weiterem Temperaturanstieg wird zum Schutz des Umrichters abgeschaltet. Bei normaler Funktion der Kühlung ist dies problemlos möglich. Versagt jedoch die Kühlung durch eine Leckage im System, so steigt die Temperatur bei Belastung aufgrund der kleinen thermischen Zeitkonstanten derart schnell an, dass zwischen Temperaturwarnung und Abschaltung nur wenige Sekunden liegen. Dies genügt in bestimmten Fällen möglicherweise nicht, um das Fahrzeug gefahrlos stillzusetzen. Beispielsweise wird bei einer Fahrt auf einer Bundesstraße der Umrichter nur mäßig belastet. D.h. die Temperatur des Umrichters erreicht sicher auch bei Ausfall der Kühlung nicht die Warnschwelle. Bei einem Überholvorgang jedoch wird die Belastung aus diesem Zustand heraus auf maximale Leistung erhöht. Wenn dann die Kühlung ausgefallen ist, steigt die Temperatur sehr schnell über die Schwelle für Warnung und Abschaltung an, so dass gegebenenfalls mitten im Überholvorgang die verfügbare Leistung reduziert wird oder komplett wegfällt. Dies kann zu kritischen Fahrsituationen führen.

Aus der Druckschrift DE 10 2004 018 578 A1 ist ein Verfahren und eine Vorrichtung zur Erfassung eines Verschmutzungsgrades eines betriebenen Umrichtergeräts bekannt. Die Vorrichtung weist ein Temperaturmodell, einen Temperatursensor und eine Auswerteschaltung auf. Der Temperatursensor ist am Bauelement des Umrichtergeräts platziert, dessen Temperatur gemessen werden soll. Beim Temperaturmodell handelt es sich um ein an sich bekanntes Temperaturmodell für einen Kühlkörper. Mit diesem Temperaturmodell wird abhängig von einer tatsächlichen Verlustleistung und einer tatsächlichen Kühlmitteltemperatur eine zu erwartende Kühlkörpertemperatur ermittelt. Bei Verschmutzung des Kühlkörpers des Umrichtergeräts ist eine gemessene Kühltemperatur höher als die geschätzte Kühlkörpertemperatur des Temperaturmodells. Als Vergleichswert erhält man einen negativen Wert. Dies signalisiert, dass der Kühlkörper des Leistungsteils des Umrichtergeräts schlechter arbeitet als vorgesehen.

Ein gattungsgemäßes Verfahren ist aus der Druckschrift WO 2005/101431 A1 bekannt. Dort wird die Temperatur eines Umrichters mittels eines thermischen Modells ermittelt und von einem Temperatursensor gemessen. Die geschätzte und gemessene Temperatur werden verglichen, und ein Warnsignal wird generiert.

Die Druckschrift EP 1 583 197 A2 offenbart ein Verfahren zum Schutz von Leistungshalbleiterkomponenten, die in einem Umrichter eingesetzt werden. Das Temperaturmodell wird dazu verwendet, den Erwärmungsgrad des Halbleiterübergangs des Leistungshalbleiters zu berechnen, wobei als Basis die äußere Oberfläche oder ein Kühlelement verwendet wird.

Darüber hinaus wird in dem Dokument US 2005/0270707 A1 beschrieben, wie die Ausgangsleistung dazu verwendet wird, über ein thermisches Modell die Temperatur eines abgeschlossenen Motors beziehungsweise eines Anschlusskabels zu schätzen.

Ferner zeigt die Druckschrift US 2004/0008457 A1 einen Überhitzungsschutz eines Umrichters. Eine Temperaturerfassungsschaltung detektiert eine Temperaturänderung des Umrichters. Bei Überhitzung wird ein entsprechendes Warnsignal ausgegeben.

Die Aufgabe der vorliegenden Erfindung besteht somit darin, einen Umrichter für einen Elektromotor eines Fahrzeugs besser überwachen zu können.

Erfindungsgemäß wird diese Aufgabe gelöst durch ein Verfahren zur thermischen Überwachung eines Umrichters für einen Elektromotor eines Fahrzeugs durch Messen einer Temperatur des Umrichters, Ermitteln einer von dem Umrichter abgegebenen Leistung, Bereitstellen eines thermischen Modells des Umrichters mit der abgegebenen Leistung als Eingangsgröße, Schätzen der Temperatur des Umrichters mit dem thermischen Modell anhand der ermittelten, abgegebenen Leistung, Vergleichen der geschätzten Temperatur mit der gemessenen Temperatur und Bereitstellen eines Überwachungssignals auf der Grundlage des Vergleichs.

Darüber hinaus ist erfindungsgemäß vorgesehen eine Überwachungsvorrichtung zur thermischen Überwachung eines Umrichters für einen Elektromotor eines Fahrzeugs mit einer Messeinrichtung zum Messen einer Temperatur des Umrichters sowie umfassend eine Erfassungseinrichtung zum Ermitteln einer von dem Umrichter abgegebenen Leistung, eine Recheneinrichtung, in der ein thermisches Modell des Umrichters mit der abgegebenen Leistung als Eingangsgröße bereitgestellt ist, und mit der die Temperatur des Umrichters mit dem thermischen Modell anhand der ermittelten, abgegebenen Leistung schätzbar ist, eine Vergleichseinrichtung zum Vergleichen der geschätzten Temperatur mit der gemessenen Temperatur und eine Signalausgabeeinrichtung zum Bereitstellen eines Überwachungssignals auf der Grundlage des Vergleichs.

In vorteilhafter Weise wird also die vom Umrichter abgegebene Leistung, also eine elektrische Leistung, ermittelt. Mit Hilfe eines thermischen Modells lässt sich daraus die Temperatur schätzen, die der Umrichter besitzt. Parallel dazu wird die Temperatur des Umrichters gemessen. In vorteilhafter Weise kann die Temperatur des Umrichters so auch in einem niedrigeren Wertebereich weit vor Erreichen einer Warnschwelle überwacht und plausibilisiert werden. Dadurch kann dem Fahrer bereits dann eine Warnung gegeben werden, wenn die Temperatur des Umrichters bei verhältnismäßig geringer abgegebener Leistung unerwartet hoch steigt.

Vorzugsweise wird in dem thermischen Modell aus der abgegebenen Leistung zunächst eine Verlustleistung berechnet. Die Verlustleistung lässt sich in üblicher Weise aus der gesamten elektrischen Leistung berechnen, wenn der Wirkungsgrad des Umrichters bekannt ist. Die Verlustleistung ist dann diejenige Leistung, die für die Erwärmung des Umrichters verantwortlich ist.

In dem thermischen Modell kann die Verlustleistung über einen vorgegebenen Rechenzeitabschnitt gemittelt und normiert werden, und die normierte Verlustleistung kann dann in dem thermischen Modell als Faktor für die Schätzung der Temperatur auftreten. Mit diesem einfachen Modell steigt die geschätzte Temperatur des Umrichters linear mit der Verlustleistung.

Darüber hinaus kann das thermische Modell eine lineare Funktion über der Zeit sein. Auch dies stellt eine Vereinfachung dar, die deutliche Rechenvorteile mit sich bringt.

Eine Zeitkonstante für das thermische Modell kann experimentell ermittelt werden. Die geschätzte Temperatur kann dann proportional zu einem Quotienten aus gemessener Zeit und der experimentell ermittelten Zeitkonstante sein. In die experimentelle Ermittlung der Zeitkonstante können mehrere Versuche eingehen, über die ein vorbestimmter Temperaturanstieg zeitlich gemittelt wird.

Insbesondere kann in dem thermischen Modell eine Kühlleistung berücksichtigt werden, mit der der Umrichter gekühlt wird. Damit kann beispielsweise für die Schätzung der Umrichtertemperatur berücksichtigt werden, ob und gegebenenfalls wie stark der Umrichter durch zusätzliche Maßnahmen (z.B. Flüssigkeitskühlung) gekühlt wird.

Des Weiteren kann in dem thermischen Modell eine Starttemperatur des Umrichters zu Grunde gelegt werden, die bei einem Start des Fahrzeugs oder als Ausgangspunkt für eine Schätzung gemessen wird. Somit werden auch Umgebungsbedingungen des Fahrzeugs für die Schätzung der Umrichtertemperatur berücksichtigt.

Hierbei ist es vorteilhaft, wenn in dem thermischen Modell die gemessene Starttemperatur als Faktor auftritt. Damit ergibt sich ein verhältnismäßig einfaches thermisches Modell.

Des Weiteren kann auf der Basis des Überwachungssignals ein Warnsignal erzeugt werden, wenn die Differenz zwischen geschätzter und gemessener Temperatur ein vorgegebenes Maß übersteigt. Ein derartiges Warnsignal informiert den Fahrer, dass die Kühlung des Umrichters nicht erwartungsgemäß vonstatten geht.

Die vorliegende Erfindung wird nun anhand der beigefügten Zeichnungen näher erläutert, in denen zeigen:

FIG 1     ein Temperaturmodell mit einer ersten Zeitkonstante und

FIG 2     ein Temperaturmodell mit einer zweiten Zeitkonstante, die gegenüber der ersten Zeitkonstante halbiert ist.

Die thermische Zeitkonstante, also diejenige Zeit, in der sich der Umrichter um einen vorbestimmten Temperaturwert erwärmt, unterscheidet sich mit und ohne funktionierender Wasserkühlung deutlich. Die Zeitkonstante bei bestimmungsgemäßem Einsatz kann leicht ermittelt werden und im Umrichter beziehungsweise seinem Überwachungssystem hinterlegt werden. Mit der Zeitkonstante kann ein thermisches Modell der Umrichtertemperatur erstellt werden.

Wesentlicher Faktor des thermischen Modells ist die Verlustleistung des Umrichters. Die Verlustleistung ist diejenige Leistung, die letztendlich im Umrichter in Wärme umgesetzt wird. Sie kann gemäß folgender Formel ermittelt werden:

$$P_V = (1 - \eta)\ P_{ges}$$

dabei entspricht η dem Wirkungsgrad des Umrichters, also dem Quotienten aus Ausgangsleistung und Eingangsleistung. $P_{ges}$ entspricht der Eingangsleistung, d.h. der gesamten in den Umrichter fließenden Leistung. Diese Leistung $P_{ges}$ lässt sich aus der üblicherweise zur Regelung des Antriebs vorhandenen Größen wie Zwischenkreisspannung und Ausgangsstrom errechnen.

Der Wirkungsgrad des Umrichters kann beispielsweise experimentell bei einer Typprüfung ermittelt werden. Dabei kann unter Umständen auch eine Abhängigkeit des Wirkungsgrads von anderen Größen, wie Umgebungstemperatur, berücksichtigt werden.

Aus Typprüfergebnissen bei Erwärmungstests kann außerdem die thermische Zeitkonstante des Systems ermittelt werden, also diejenige Zeit, in der sich die Temperatur des Systems um einen vorgegebenen Temperaturwert erhöht. Diese thermische Zeitkonstante wird, wie oben bereits angedeutet wurde, im Umrichter abgelegt und steht dann zur Berechnung bzw. Schätzung der bei einem bestimmten Betriebszustand zu erwartenden Umrichtertemperatur zur Verfügung. Das entsprechende thermische Modell zur Schätzung der Umrichtertemperatur θ kann wie folgt lauten:

$$\Theta(t) := \left[ T_0\left(1 + \frac{t}{\tau}\right) \right] * \tilde{P}_v$$

Dabei sind $T_0$ die Starttemperatur für die Schätzung, eine normierte, mittlere Verlustleistung im letzten Rechenzeitabschnitt und $\tau$ die experimentell ermittelte Zeitkonstante. Die Starttemperatur $T_0$ kann mit der Temperatur des Umrichters beim Start des Fahrzeugs übereinstimmen, sie wird es in der Regel jedoch nicht. Die Starttemperatur $T_0$ ist vielmehr allgemein diejenige Temperatur, die für einen Rechenzeitabschnitt als Ausgangspunkt dient. Die mittlere Verlustleistung $\tilde{P}_v$ ist hinsichtlich einer vorgegebenen Leistung oder einer experimentell ermittelten Leistung normiert.

Das oben dargestellte thermische Modell ist bewusst sehr einfach gehalten. Damit ist eine verhältnismäßig geringe Rechenleistung zur Schätzung der Temperatur erforderlich. Grundsätzlich können aber auch andere Temperaturmodelle für die Schätzung der Umrichtertemperatur verwendet werden. Insbesondere können sie auch deutlich aufwändiger in der Berechnung sein. Beispielsweise kann das thermische Modell komplexer werden, wenn eine zusätzliche Luftkühlung des Umrichters berücksichtigt wird.

Die mit Hilfe des thermischen Modells berechnete bzw. geschätzte Temperatur wird mit einer gemessenen Temperatur des Umrichters verglichen. Im Fehlerfall weicht die gemessene Temperatur auch im Teillastbereich schon deutlich von der berechneten Temperatur ab. Dies bedeutet, dass beispielsweise bei einem Fahrzeug, das mit geringer Leistung in der Ebene bewegt wird, eine wesentlich höhere Temperatur gemessen wird als sie erwartet wird. Auch wenn die gemessene Temperatur noch keinen systemkritischen Punkt erreicht hat, hat man bereits die Möglichkeit, dem Fahrer das Versagen der Kühlung zu melden. Der Umrichter ist dann noch voll funktionsfähig, und damit ist auch das Fahrzeug noch voll manövrierbar. Durch den Abgleich bzw. Vergleich zwischen Schätzung und Messung wird eine Abweichung der thermischen Zeitkonstante ermittelt, die die erste Folge des Versagens der Flüssigkeitskühlung durch eine Leckage/Ausfall der Kühlmittelpumpe ist. Der schnelle Temperaturanstieg ist wiederum eine Folge der Veränderung dieser Zeitkonstante. D.h. es wird eine Ursache für das schnelle Ansteigen der Temperatur detektiert, die so bisher nicht zugänglich war. Dadurch wird es möglich, die Vorwarnzeit für den Fahrzeugführer wieder auf Werte zu bringen, wie sie der Fahrer aus üblichen Verbrennungskraftmaschinen gewohnt ist.

Die Schätzung und Überwachung der Temperatur des Umrichters kann mit Hilfe von Software im Umrichter realisiert werden. Da es sich um thermische Zustände handelt, kann die Berechnung in niederprioren Zeitscheiben erfolgen. Trotzdem wird sie auch dann ausreichend akkurat ausfallen.

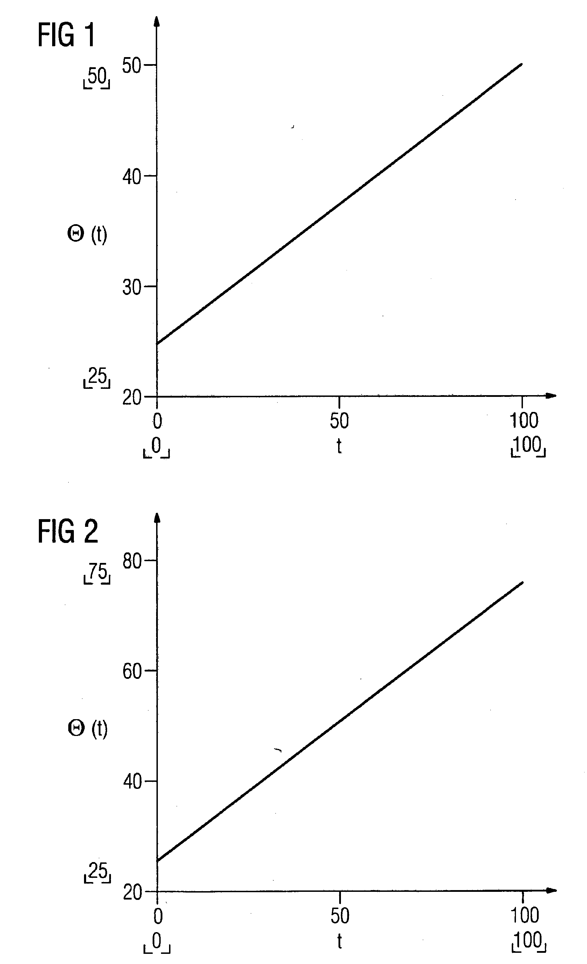

In den FIG 1 und 2 sind jeweils die Temperaturen über der Zeit bei verschiedenen thermischen Modellen dargestellt. Es wird das oben angegebene lineare Modell vorausgesetzt. Als normierte mittlere Verlustleistung $\tilde{P}_v$ wird der Wert 1 angenommen. Für eine Zeitkonstante $\tau$ = 50 s und einer Starttemperatur $T_0$ = 25° C ergibt sich dann der in FIG 1 dargestellte Verlauf der geschätzten Temperatur θ (t). Die geschätzte Temperatur steigt von dem Ausgangswert 25° C auf den Endwert von 50° C nach 100 s.

Wird hingegen eine thermische Zeitkonstante $\tau$ = 50 s ermittelt, so ergibt sich der lineare Verlauf von FIG 2. Demnach steigt die geschätzte Temperatur θ(t) vom Ausgangswert 25° C auf 75° C. Im Fall von FIG 2 hat also der Umrichter eine kleinere thermische Zeitkonstante als in FIG 1. Der Grund hierfür kann darin liegen, dass der Umrichter von FIG 2 weniger stark gekühlt wird als derjenige von FIG 1.

Liegt die gemessene Temperatur jeweils deutlich über derjenigen, die mit Hilfe des thermischen Modells geschätzt wurde, so kann dies als Indiz dafür gesehen werden, dass die Kühlung nicht in gewünschter Weise arbeitet. Durch die erfindungsgemäße Plausibilisierung der gemessenen Umrichtertemperatur muss das Kühlsystem nicht direkt überwacht werden. Insbesondere muss nicht die Fließgeschwindigkeit und der Druck im Kühlsystem gemessen werden, aus denen auf einen Ausfall der Kühlmittelpumpe bzw. eine Leckage mit Druckverlust geschlossen werden könnte.

Häufig kann auf zusätzliche Sensoren verzichtet werden, die zusätzliche Kosten und eine erhöhte Komplexität und Fehleranfälligkeit des Systems mit sich bringen würden.

**Patentansprüche**

1. Verfahren zur thermischen Überwachung eines Umrichters für einen Elektromotor eines Fahrzeugs durch

   - Messen einer Temperatur des Umrichters,
   - Bereitstellen eines thermischen Modells des Umrichters,
   - Schätzen der Temperatur des Umrichters mit dem thermischen Modell,
   - Vergleichen der geschätzten Temperatur ($\theta$) mit der gemessenen Temperatur und
   - Bereitstellen eines Überwachungssignals auf der Grundlage
   des Vergleichs,

   **gekennzeichnet durch**

   - Ermitteln einer von dem Umrichter abgegebenen Leistung, wobei
   - das thermische Modell die abgegebene Leistung als Eingangsgröße hat, und
   - das Schätzen der Temperatur anhand der ermittelten, abgegebenen Leistung erfolgt.

2. Verfahren nach Anspruch 1, wobei in dem thermischen Modell aus der abgegebenen Leistung zunächst eine Verlustleistung berechnet wird.

3. Verfahren nach Anspruch 2, wobei in dem thermischen Modell die Verlustleistung über einen vorgegebenen Rechenzeitabschnitt gemittelt und normiert wird, und die normierte Verlustleistung in dem thermischen Modell als Faktor für die Schätzung der Temperatur auftritt.

4. Verfahren nach einem der vorhergehenden Ansprüche, wobei das thermische Modell eine lineare Funktion über der Zeit ist.

5. Verfahren nach Anspruch 4, wobei eine Zeitkonstante für das thermische Modell experimentell ermittelt wird.

6. Verfahren nach einem der vorhergehenden Ansprüche, wobei in dem thermischen Modell eine Kühlleistung berücksichtigt wird, mit der der Umrichter gekühlt wird.

7. Verfahren nach einem der vorhergehenden Ansprüche, wobei in dem thermischen Modell eine Starttemperatur des Umrichters zu Grunde gelegt wird, die bei einem Start des Fahrzeugs oder als Ausgangspunkt für eine Schätzung gemessen wird.

8. Verfahren nach einem der vorhergehenden Ansprüche, wobei in dem thermischen Modell die gemessene Starttemperatur als Faktor auftritt.

9. Verfahren nach einem der vorhergehenden Ansprüche, wobei auf der Basis des Überwachungssignals ein Warnsignal erzeugt wird, wenn die Differenz zwischen geschätzter und gemessener Temperatur ein vorgegebenes Maß überschreitet.

10. Überwachungsvorrichtung zur thermischen Überwachung eines Umrichters für einen Elektromotor eines Fahrzeugs mit

   - einer Messeinrichtung zum Messen einer Temperatur des Umrichters,
   - einer Recheneinrichtung, in der ein thermisches Modell des Umrichters bereitgestellt ist, und mit der die Temperatur des Umrichters mit dem thermischen Modell schätzbar ist,
   - eine Vergleichseinrichtung zum Vergleichen der geschätzten Temperatur mit der gemessenen Temperatur und
   - eine Signalausgabeeinrichtung zum Bereitstellen eines
   Überwachungssignals auf der Grundlage des Vergleichs,

   **gekennzeichnet durch**

- eine Erfassungseinrichtung zum Ermitteln einer von dem Umrichter abgegebenen Leistung, wobei
- das thermische Modell die abgegebene Leistung als Eingangsgröfe hat, so dass die Temperatur des Umrichters anhand der ermittelten, abgegebenen Leistung schätzbar ist.

**Claims**

1.  Method for the thermal monitoring of a converter for an electric motor of a motor vehicle by

    - measuring a temperature of the converter,
    - providing a thermal model of the converter,
    - estimating the temperature of the converter with the thermal model,
    - comparing the estimated temperature ($\theta$) with the measured temperature and
    - providing a monitoring signal on the basis of the comparison,

    **characterised by**

    - determining a power output by the converter, wherein
    - the thermal model has the output power as an input variable, and
    - the temperature is estimated with the aid of the determined, output power.

2.  Method according to claim 1, wherein a loss of power is initially calculated in the thermal model from the output power.

3.  Method according to claim 2, wherein the loss of power is averaged and standardised in the thermal model by way of a predetermined computing time section, and the standardised loss of power in the thermal model occurs as a factor for the estimation of the temperature.

4.  Method according to one of the preceding claims, wherein the thermal model is a linear function over time.

5.  Method according to claim 4, wherein a time constant for the thermal model is determined experimentally.

6.  Method according to one of the preceding claims, wherein a cooling power is taken into account in the thermal model, with which cooling power the converter is cooled.

7.  Method according to one of the preceding claims, wherein a start temperature of the converter underlies the thermal model, said start temperature being measured when starting up the vehicle or as starting point for an estimation.

8.  Method according to one of the preceding claims, wherein the measured start temperature occurs as a factor in the thermal model.

9.  Method according to one of the preceding claims, wherein a warning signal is generated on the basis of the monitoring signal, if the difference between estimated and measured temperature exceeds a predetermined value.

10. Monitoring apparatus for the thermal monitoring of a converter for an electric motor of a vehicle having

    - a measuring facility for measuring a temperature of the converter,
    - a computing facility, in which a thermal model of the converter is provided, and with which the temperature of the converter can be estimated with the thermal model,
    - a comparison facility for comparing the estimated temperature with the measured temperature and
    - a signal outputting facility for providing a monitoring signal on the basis of the comparison,

    **characterised by**

    - a detection facility for determining a power output by the converter, wherein
    - the thermal model has the output power as an input variable so that the temperature of the converter can be estimated with the aid of the determined, output power.

**Revendications**

1. Procédé de contrôle thermique d'un convertisseur pour un moteur électrique d'un véhicule par

   - mesure d'une température du convertisseur,
   - mise à disposition d'un modèle thermique du convertisseur,
   - évaluation de la température du convertisseur par le modèle thermique,
   - comparaison de la température ( θ ) évaluée à la température mesurée et
   - mise à disposition d'un signal de contrôle sur la base de la comparaison

   **caractérisé par**

   - une détermination d'une puissance cédée par le convertisseur, dans lequel
   - le modèle thermique a la puissance cédée comme grandeur d'entrée et
   - l'évaluation de la température s'effectue au moyen de la puissance cédée qui a été déterminée.

2. Procédé suivant la revendication 1, dans lequel, dans le modèle thermique, on calcule d'abord une puissance perdue à partir de la puissance cédée.

3. Procédé suivant la revendication 2, dans lequel, dans le modèle thermique, on fait la moyenne et on norme la puissance perdue sur un laps de temps de calcul prescrit et la puissance perdue normée apparaît dans le modèle thermique sous la forme d'un facteur pour l'évaluation de la température.

4. Procédé suivant l'une des revendications précédentes, dans lequel le modèle thermique est une fonction linéaire en fonction du temps.

5. Procédé suivant la revendication 4, dans lequel on détermine expérimentalement une constante de temps pour le modèle thermique.

6. Procédé suivant l'une des revendications précédentes, dans lequel, dans le modèle thermique, on prend en compte une puissance de refroidissement, par laquelle le convertisseur est refroidi.

7. Procédé suivant l'une des revendications précédentes, dans lequel, dans le modèle thermique, on prend pour base une température de démarrage du convertisseur, qui est mesurée lors d'un démarrage du véhicule ou comme point de départ d'une évaluation.

8. Procédé suivant l'une des revendications précédentes, dans lequel, dans le modèle thermique, la température de démarrage mesurée apparaît comme un facteur.

9. Procédé suivant l'une des revendications précédentes, dans lequel, sur la base du signal de contrôle, on produit un signal d'avertissement, si la différence entre la température évaluée et la température mesurée dépasse une valeur prescrite.

10. Dispositif de contrôle thermique d'un convertisseur pour un moteur électrique d'un véhicule comprenant

    - un dispositif de mesure d'une température du convertisseur,
    - un dispositif informatique, dans lequel un modèle thermique du convertisseur est mis à disposition et par lequel la température du convertisseur peut être évaluée par le modèle thermique,
    - un dispositif de comparaison de la température évaluée à la température mesurée et
    - un dispositif d'émission d'un signal pour mettre à disposition un signal de contrôle sur la base de la comparaison,

    **caractérisé par**

    - un dispositif de détection pour la détermination d'une puissance cédée par le convertisseur, dans lequel
    - le modèle thermique a la puissance cédée comme grandeur d'entrée, de sorte que la température du convertisseur peut être évaluée au moyen de la puissance cédée qui a été déterminée.

FIG 1

FIG 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102004018578 A1
- WO 2005101431 A1
- EP 1583197 A2
- US 20050270707 A1
- US 20040008457 A1